# EUROPEAN PATENT APPLICATION

(11) **EP 4 819 776 A1**
(43) Date of publication of application: **07.10.2026**
(21) Application number: 26162559.4
(22) Date of filing: 05.03.2026
(51) Int. Cl.: H05K 3/46, H05K 1/11, H05K 1/185, H05K 3/24, H05K 3/28, H05K 3/341

(54) **COMPONENT CARRIER AND METHOD FOR MANUFACTURING THE COMPONENT CARRIER**

(30) Priority: 31.03.2025 CN 202510399575
(71) Applicant: AT & S Austria Technologie & Systemtechnik Aktiengesellschaft, 8700 Leoben (AT)
(72) Inventor: WANG, Nina, Chongqing, 401133 (CN); REN, Raab, Chongqing, 401133 (CN); HE, Alin, Chongqing, 401331 (CN)
(74) Representative: Donatello, Daniele

(57) **Abstract**

There is described a component carrier and a method for manufacturing the component carrier. The component carrier comprises: a stack (101) comprising at least one electrically conductive layer structure (120) and a plurality of electrically insulating layer structures; a cavity (110) formed in the stack (101) and being delimited by a bottom wall (111) and a sidewall (112); wherein the bottom wall is partially delimited by a first main surface (106) of a first electrically insulating layer structure (102) of the plurality of electrically insulating layer structures; wherein the at least one electrically conductive layer structure is provided in/on the first main surface; wherein the at least one electrically conductive layer structure comprises: a first portion (121) exposed in the cavity, and a second portion (122) covered by a second electrically insulating layer structure (108) of the plurality of electrically insulating layer structures; and wherein the first portion of the at least one electrically conductive layer structure comprises a covering electrically conductive layer structure (150) in addition to the structure of the second portion.

## Description

### Field of the Invention

The invention relates to a component carrier with stack comprising at least one electrically conductive layer structure, a plurality of electrically insulating layer structures, and a cavity formed in the stack being delimited by a bottom wall and a sidewall, wherein the at least one electrically conductive layer structure comprises a first portion exposed in the cavity, and a second portion covered by a second electrically insulating layer structure of the plurality of electrically insulating layer structures, wherein the first portion of the at least one electrically conductive layer structure comprises a covering electrically conductive layer structure. The invention further relates to a method of manufacturing the component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions. In particular, embedding and electrically connecting a component in a cavity of a component carrier stack may be considered a challenge.

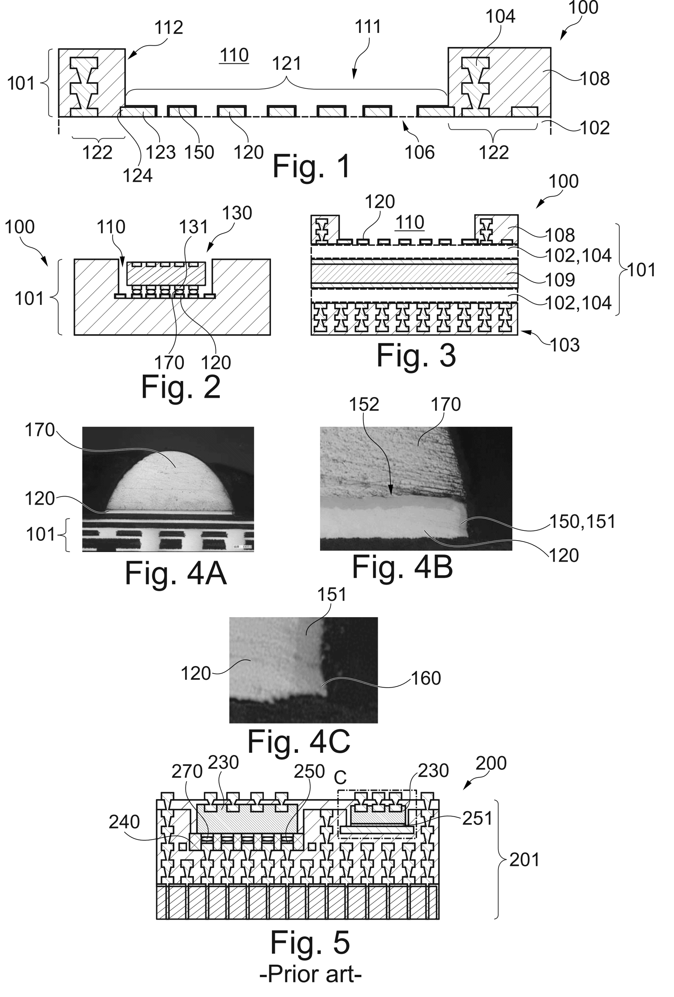

**Figure 5** shows an example of a conventional circuit board 200 comprising a layer stack 201. Components 230 are embedded in respective cavities in the stack 201. Generally, in the industry, the component embedded in the build-up is only connected with one side interconnection to the component carrier. As shown on the right side, the component 230 is fixed at the bottom of the cavity by an adhesive layer 251.

However, due to the trend towards high-performance computing and high frequency application requirement in the market, such a one side interconnection between the component carrier and the component may not be sufficient to meet intense signal transmission requirements. Therefore, double side interconnection between the component and component carrier may be an efficient technical solution to meet such requirements.

As shown on the left side, a resin 240 is arranged at the bottom of the cavity and the component 230 is placed onto said resin 240. Electric connections 250 are formed through the resin 240 to electrically contact electric pads at the bottom of the component 230. In this example, a solder ball 270 is arranged between the electric connection 250 and the electric pad of the component 230. In order to provide solderability properties, the upper surface of the electric connection 250 is treated by electrolytic palladium/gold (Pd/Au) before cavity formation.

However, providing such a treatment may be costly and cumbersome. For example, electrolytic Pd/Au may cause drawbacks regarding resilience, solderability, costs and yield.

### Summary of the Invention

There may be a need to provide a component carrier cavity, in particular for embedding a component, in an efficient and reliable manner.

According to exemplary embodiments of the invention, a component carrier, and a method of manufacturing are described.

According to an aspect of the invention, there is described a component carrier (e.g. a printed circuit board, an IC substrate, an interposer, etc.) comprising:
i) a (multilayer) stack comprising at least one electrically conductive layer structure (e.g. traces, pads, vias, etc.) and a plurality of electrically insulating layer structures (e.g. reinforced or non-reinforced resin);
ii) a cavity formed in the stack and being delimited by a bottom wall and a sidewall (e.g. defined by at least one of the electrically insulating layer structures).

The bottom wall is partially delimited by a first main surface of a first electrically insulating layer structure of the plurality of electrically insulating layer structures (arranged below the cavity).

The at least one electrically conductive layer structure is provided in/on the first main surface (e.g. by plating).

The at least one electrically conductive layer structure comprises:
a) a first portion exposed in the cavity, and
b) a second portion covered by a second electrically insulating layer structure of the plurality of electrically insulating layer structures (in particular the second electrically insulating layer structure defines at least partially the lateral wall of the cavity).

Further, the first portion of the at least one electrically conductive layer structure comprises a covering electrically conductive layer structure (e.g. a surface finish layer and/or other organic protection layer) (in addition to the structure of the second portion).

According to a further aspect of the invention, there is described a method for manufacturing a component carrier, the method comprising:
i) providing a stack comprising at least one electrically conductive layer structure and a plurality of electrically insulating layer structures;
ii) forming a cavity in the stack, being delimited by a bottom wall and a sidewall, wherein the bottom wall is partially delimited by a first main surface of a first electrically insulating layer structure of the plurality of electrically insulating layer structures, and wherein the at least one electrically conductive layer structure is provided in/on the first main surface;
iii) providing a covering (electrically conductive) layer structure (e.g. a surface finish and/or organic solder protection layer) on the at least one electrically conductive layer structure (in particular after cavity formation),
so that the at least one electrically conductive layer structure comprises:
a first portion exposed in the cavity, wherein the first portion comprises the covering (electrically conductive) layer structure in addition to the structure of a second portion, and
the second portion covered by a second electrically insulating layer structure of the plurality of electrically insulating layer structures.

In the context of the present document, the term "electrically conductive layer structure" may particularly denote any layer structure that is electrically conductive, e.g. a metal (e.g. copper) layer structure. Such an electrically conductive layer structure may comprise at least one of metal structures, traces, pads, electric connections, vias, terminals, a foil, a patterned layer/foil or bumps. In an embodiment, the electrically conductive layer structure is configured as a plurality of electrically conductive structures (in the same horizontal/planar layer) on the first main surface. In an embodiment, a layer of (isolated/separated) traces/pads is provided on said first main surface as the electrically conductive layer structure (e.g. by plating). In such an example of separated/isolated structures, there may be free spaces (gaps) in between, exposing the first main surface. At least one (structure of the) electrically conductive layer structure may be exposed at the cavity bottom. Further, at least one (structure of the) electrically conductive layer structure may be covered by the (second) electrically insulating layer structure. In an embodiment, the exposed at least one (structure of the) electrically conductive layer structure may be termed first portion, while the covered (by insulating material) at least one (structure of the) electrically conductive layer structure may be termed second portion.

In the context of the present document, the term "covering electrically conductive layer structure" may particularly denote any electrically conductive layer structure suitable to cover the above described electrically conductive layer structure. Hereby, the covering electrically conductive layer structure may comprise a different material (or the same material) as the electrically conductive layer structure. In an embodiment, the covering electrically conductive layer structure covers the (upper) main surface and/or the lateral surfaces of the electrically conductive layer structure. In an embodiment, the covering electrically conductive layer structure covers only/exclusively the exposed (first portion of the) electrically conductive layer structure. In another embodiment, the covering electrically conductive layer structure covers at least a part of the covered (by insulating material) (second portion of the) electrically conductive layer structure; in other words, the covering electrically conductive layer structure partially extended in between the (second portion of the) electrically conductive layer structure and the (second) electrically insulating layer structure.

In an embodiment, the electrically conductive layer structure comprises structures/traces/pads and each of said structures (of the first portion) is individually covered by material of the covering electrically conductive layer structure. In an embodiment, the covering electrically conductive layer structure is configured as a surface finish, for example ENIG or ENEPIG or ENIG-LP (consists of a low phosphorus electroless nickel layer followed by an immersion gold layer). In a further embodiment, the covering electrically conductive layer structure comprises two or more layers, e.g. a seed layer and a plated layer and/or an intermediate layer and a protection layer. In a specific embodiment, in particular referring to the manufacture method, a covering layer structure is used that may be (at least partially) organic, for example organic solder protection (OSP).

In an embodiment, the covering electrically conductive layer comprises an IMC (intermetallic compound) layer. The IMC layer may comprise the composition of the electrically conductive layer structure (such as copper), since the electrically conductive material may migrate with very low volume and merge with the surface finish layer (the covering electrically conductive layer structure). The IMC layer may comprise the composition of the component soldering or bonding structure (such as Sn), since the soldering material and the material in the surface finish layer may react with each other and merge into an IMC layer. The IMC layer may comprise a low amount of gold or may not comprise gold, as the gold is a very stable metal and it may not migrate or merge into another layer. In an embodiment, the IMC layer may comprise a low amount/volume of phosphorus.

In the context of the present document, the term "main surface" may particularly denote a surface that is oriented along a plane in parallel to the directions of main extension (planar extension, horizontal plane, x-y) and perpendicular to a thickness direction (vertical direction, z). In an embodiment, the component carrier may comprise two directions of main extension (length, width) in the horizontal direction and a perpendicular extension (which is not a main extension) in the vertical direction (thickness). In an embodiment, such a main surface of the component carrier may be the external surface. For example, an upper main surface may be the upper external surface and a lower main surface may be the (opposed) lower external surface. In a further embodiment, the layer structures of the stack may also comprise a main surface. For example, the first electrically insulating layer structure may comprise a (upper) main surface that defines (at least partially) the cavity bottom.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive layer structures and at least one electrically insulating layer structure.

In the context of the present document, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

According to an exemplary embodiment, the invention may be based on the idea that a functional component carrier cavity can be provided in an efficient and reliable manner, when a first portion of an electrically conductive layer structure is exposed at the cavity bottom and covered by a covering electrically conductive layer structure, while a second portion of said electrically conductive layer structure is not exposed but covered by an electrically insulating layer structure (that at least partially defines the sidewalls of the cavity). Such an electrically conductive layer structure may be highly functional and robust, so that a plurality of different components/applications may be placed into the cavity. The covering electrically conductive layer structure well protects the first portion and may enable an efficient electrical contact to the component to be embedded. In particular, the covering electrically conductive layer structure may be provided efficient solderability properties (e.g. for an additional solder material). The electrically insulating material around the cavity well protects the second portion, enabling an electric connection in the stack, in particular also to the component to be embedded.

Additionally, the electrically insulating material around the cavity may also fill the gaps between the exposed electrically conductive layer structures in the first place and may then provide the advantage that the gaps can be completely filled without a void. Therefore, the reliability and quality may be ensured.

Conventionally (compare Figure 5), exposed electric contacts in a cavity are isolated and either not protected or protected in a cumbersome manner (e.g. by Pd/Au, potentially causing drawbacks regarding resilience, solderability, costs, yield). It has now been found by the inventors that a highly efficient and robust electric connection may be enabled by covering the electrically conductive layer structure at the cavity bottom in two different manners: i) by electrically insulating stack material (that defines the cavity) and ii) a surface finish layer to be provided as an inner layer in the cavity, thereby exploiting well established and efficient component carrier technology. While conventionally, a proper surface finish layer is only applied at the outermost surface of the stack, it has now been found that the surface finish may be efficiently used inside the stack, i.e. at a cavity bottom.

Advantages of this architecture may include: less manufacturing processes and lower yield loss impact (in particular when the covering electrically conductive layer structure is formed after the cavity formation), improved solderability performance and higher reliability performance. The described design may be implemented into existing component carrier lines in a straightforward manner, for example when a surface finish process for the external stack surface is already present.

### Exemplary Embodiments

In an embodiment, the covering electrically conductive layer structure covers the main surface and/or the lateral surfaces of (at least one structure/trace of) the at least one electrically conductive layer structure of the first portion. This may provide the advantage that the electrically conductive layer structure is protected (e.g. against alteration/corrosion/oxidation) and can still be efficiently electrically connected. Further, the solderability/bonding capability/signal integrity may be improved. By covering the main surface (upper surface) and the lateral surfaces, the protection/functionalization may be especially efficient. In an embodiment, the electrically conductive layer structure comprises several structures (e.g. traces, pads, vias, bumps etc.) in the first portion, one or each of them being covered by the covering electrically conductive layer structure.

Generally, the covering electrically conductive layer structure may not only protect the electrically conductive layer structure for the products which are applied in the final product, but may also protect the electrically conductive layer of the semi-finished product, as there may always be queue times (waiting time) before soldering for the (semi-finished) product in a production line. If there is no covering electrically conductive layer structure applied, the electrically conductive layer structure exposed may be easily oxidized and corroded, which may result in a decrease of quality and reliability issue for the whole product. With such a kind of situation, the whole product may be scrapped, as it cannot be repaired, so that the yield loss may be high and the cost of high volume production for the product may also be high.

In an embodiment, the covering electrically conductive layer structure covers the structure of the first portion (upper main surface, lateral surface) that is not covered by the first main surface (lower surface). In other words, the covering layer covers all the exposed portion with the exception of the surfaces of the first electrically insulating structure, where the first portion is provided on. This may provide the advantage that the electrically conductive layer structure in the cavity is well protected and reliable as the covering electrically conductive layer structure may not only avoid the corrosion and oxidation on the first portion, but may also provide a good soldering surface for the bonding structure with a very solid IMC layer (such as a solderball) to connect with the component.

In an embodiment, the covering electrically conductive layer structure comprises at least two layers, in particular exactly two layers. By providing two or more layers, different properties/advantages may be provided that may favorably function in synergy and/or complement each other.

In an embodiment, the (covering) electrically conductive layer structure comprises a seed layer and a plated layer. The seed layer may hereby be used to enable an efficient plating process. Such a seed layer may be provided in an electroless manner, e.g. physical/chemical vapor deposition; for example, Ti/Cu can be used to provide the seed layer. Plating in turn may be done for example using copper. In a further embodiment, a nickel layer may be plated. Normally, the plated layer is (significantly) thicker than the seed layer.

In an embodiment, the covering electrically conductive layer structure comprises an intermediate layer (in particular comprising nickel deposited on the electrically conductive layer structure) and/or may comprise an additional layer on the intermediate layer (comprising palladium deposited on the nickel to protect the nickel layer and configuring as catalyst for the protective layer deposition) and/or a protective layer (comprising gold which may deposit on the palladium layer or the nickel layer). The protective layer may provide an efficient shielding against alteration and/or oxidation and/or corrosion. Since a protection material, such as gold, may be expensive, the protective layer can be made very thin (e.g. less than 100 nm). An intermediate layer (e.g. nickel) can provide sufficient stability/adhesion for the protective layer. In an embodiment, the covering electrically conductive layer structure may be configured as an ENIG layer or ENIPIG or ENEPIG layer, wherein the intermediate layer may correspond to the electroless nickel and the protective layer may correspond to the immersion gold and/or the additional layer may correspond to electroless palladium or immersion palladium. The ENIG may be ENIG low phosphorous, which comprises low content of phosphorous, and the low content of phosphorus can provide a good solderability and conductivity with low cost. Thus, an established and reliable material (normally used at the external surface) is used efficiently within a cavity for component carrier connection. In an embodiment, the protective layer is provided on the side opposite to the seed layer, in particular with the intermediate layer in between.

In an embodiment, the protective layer faces, in particular is exposed to, the internal space of the cavity. In other words, the protective layer may be the outermost/external layer of the covering electrically conductive layer structure. Hence, an efficient and reliable protection may be provided to the electrically conductive layer structure and the other layers of the covering electrically conductive layer structure, since the protective layer may have a very stable material and may have a good conductivity.

In an embodiment, the intermediate layer is thicker than the protective layer. This measure may save costs/efforts, since the material of the protective layer (such as gold) may be expensive. Besides that, the intermediate layer can prevent the electrically conductive layer immigrating to the surface to ensure that the electrically conductive layer does not react with the soldering material to impact the soldering quality, so that it may provide a reliable support for the protection functionality.

In an embodiment, after soldering with another metal element such as tin, the covering electrically conductive layer may become an IMC layer with Sn (the IMC layer comprises mainly Ni and Sn; even there may be gold and or palladium as both materials are only present in very low amounts, e.g. a layer less than 50 nm, respectively). The intermediate layer can react with the soldering material and form a stable IMC layer, which may have a good adhesion without cracking. The intermediate layer may not only prevent the copper immigration and provide a mechanical stable surface for the soldering while producing the product, but may also impact the capability of the soldering reliability, corrosion resistance, and the signal integrity in a long term.

In an example (e.g. ENIG), the nickel may serve as a barrier and adhesion layer between the metal (copper) and the gold layer. The nickel layer may serve as a diffusion barrier that prevents copper from diffusing with/into the next layer and also an antioxidant that prevents copper from being oxidized; ensuring long-term solderability and the integrity/conductivity of copper. Further, the nickel layer may act as a stable base for the gold layer, ensuring a smooth and even surface (adhesion). Nickel is further mechanically stable and may support strong solder joints. In an embodiment, the component carrier preform is immersed in a nickel-phosphorus (Ni-P) plating bath, to provide the electro-less nickel. In an embodiment, gold is generally a very stable element, and may not migrate or react with other metals. Gold may stay for a good protection of layers below. Nickel may be used to prevent the copper migrating or extend to external and merge with the IMC layer of NiSn.

In an embodiment, no further layer is arranged between the intermediate layer and the protective layer. In an embodiment, no further layer is arranged between the electrically conductive layer structure of the first portion and the intermediate layer. These embodiments may describe a two-layer covering electrically conductive layer structure, where the intermediate layer is arranged directly on the first portion, and the protective layer is arranged directly on the intermediate layer. By providing these layers only, costs/efforts may be saved, while efficiency may be high.

In an embodiment, the covering electrically conductive layer structure, in particular the intermediate layer, defines a foot-structure, in particular a nickel-foot, at the bottom wall of the cavity. Such a foot-like structure (protrusion) may be the footprint of providing the intermediate (nickel) layer in a manufacture process. For example, the electrically conductive layer structure may be immersed in a nickel bath to deposit the electro-less nickel-layer. Nickel material may flow around the sidewall of the electrically conductive layer structure and remain at the bottom of said sidewall as a residue.

In an embodiment, the foot-structure is arranged at an interface of the first main surface and the (covering) electrically conductive layer structure. Thereby, the foot-structure may provide a larger contact surface with the first main surface and thereby increase stability for the covering electrically conductive layer structure and the adhesion between the covering electrically conductive layer structure and electrically conductive layer structure and the first main surface. Therefore, the certain level of foot (less than 2 µm) can provide an anchor point for adhering with other layers.

In an embodiment, the bottom wall of the cavity is delimited by the first portion of the at least one electrically conductive layer structure and the exposed part of the first main surface of the first electrically insulating layer structure. The first main surface may be the upper/external main surface of the second electrically insulating layer structure below the cavity. The electrically conductive layer structure may be provided directly on said first electrically insulating layer structure. Thus, no further materials/means are necessary to define the bottom wall of the cavity. In an embodiment, a part of the covering electrically conductive layer structure may also delimit the bottom wall, e.g. by the foot-structure.

In an embodiment, with a design, the component can have a double side connection directly with the component carrier, after the component is embedded in the cavity and interconnected with the component carrier inside of the cavity. Thus, the direct connection between the component and the component carrier, by the interconnection structure, can provide a short electrical signal transmission path, so that the integrity of the signal may be improved and the loss of the signal may be reduced; meanwhile, the transmission speed between the component and the component carrier may be increased, which may be advantageous for high performance computing, such as for the application of an AI server.

In an embodiment, the sidewall of the cavity is laterally delimited by at least one, preferably by a plurality, of layer structures of the stack. In an embodiment, at least one further electrically conductive layer structure and/or the second electrically insulating layer structure is in direct contact with the first main surface (of the first electrically insulating layer structure). In an embodiment, the sidewall is at least partially defined by the second electrically insulating layer structure of the plurality of electrically insulating layer structures. In other words, the cavity may be formed in exactly one layer structure of the stack or in two or more layer structures (e.g. a build-up block). In an example, the cavity is formed in exactly one electrically insulating layer structure. In another example, electrically conductive layer structure and electrically insulating layer structures (alternating) may form the sidewalls of the cavity. This may increase the design flexibility and enable many different applications.

In an embodiment, a further electrically conductive layer structure of the plurality of electrically conductive layer structures is provided on a surface, in particular main surface, of one of the plurality of electrically insulating layer structures. In an embodiment, the further electrically conductive layer structure defines at least partially the sidewall or is arranged below the cavity. In an embodiment, the further electrically conductive layer structure comprises a further covering electrically conductive layer structure that is different from the covering electrically conductive layer structure on the first portion. In an embodiment, the further electrically conductive layer structure may be free of the covering electrically conductive layer structure, as it may be merely configured as a laser stop layer and the component may not be connected with it.

In an embodiment, a further (electrically conductive) layer structure is the outermost (electrically conductive) layer structure of the stack. In an embodiment, the outermost electrically conductive layer structure is at the side of the cavity opening. In an embodiment, the further layer structure is the outermost layer, e.g. at least one of a solder resist, a surface finish, an OSP. In a further embodiment, the further layer structure is at least partially covered by a further covering (electrically conductive) layer structure, e.g. comprising a surface finish and/or OSP. In an embodiment, the further covering layer structure is similar or different with respect to the covering electrically conductive layer structure.

In an embodiment, the further electrically conductive layer structure comprises via connections and/or pads/traces. In an embodiment, the further electrically conductive layer structure is arranged at least partially in (extends at least partially through) a solder resist layer (e.g. the further layer structure). In an embodiment, a further covering (electrically conductive) layer structure is arranged on said via connections and/or pads/traces, thereby providing efficient protection to the exposed electric connections and/or increasing solderability. Therefore, the components with high performance computing can be bonded with the further electrically conductive layer structure with good soldering quality and the final IC package can be produced with good reliability and quality.

In an embodiment, the further covering (electrically conductive) layer structure comprises a surface finish, for example ENIG or ENEPIG. In an embodiment, the covering electrically conductive layer structure and the further covering electrically conductive layer structure are similar or different. This may provide the advantage that established surface finish techniques can be applied to the external surface of the stack as well as to an internal cavity of the stack.

In a further embodiment, the further covering layer structure comprises or consists of an organic layer structure, for example organic solder protection (OSP). Such a covering material may be different from or the same as the electrically conductive covering material in the cavity and increase the solderability.

In an embodiment, considering that the covering electrically conductive layer structure is embedded in the stack of component carrier, it is not exposed in the environment and impacted by the air after the final application product is assembled, so that ENIG or OSP with lower cost may be enough to provide a covering layer for the protection. However, for the further covering layer structure on the external surface of the stack, it is exposed to the environment, and it may need further protection; therefore ENEPIG or ENIPIG, which comprise further metal palladium with high cost, may be required.

In an embodiment, the at least one electrically conductive layer structure in/on said first main surface comprises an edge portion, positioned across the sidewall of the cavity, in particular so that a first sub-portion of the edge portion is exposed in the cavity and a second sub-portion of the edge portion is not exposed in the cavity and is embedded in the stack (in particular in the second electrically insulating layer structure). The edge-portion may hereby refer to a region, where a part of a structure/trace of the electrically conductive layer structure is covered by electrically insulating material (second portion) and another part is free of electrically insulating material (first portion). Thus, a differentiation between first portion and second portion may also be applicable to a single structure/trace. A partial embedding of the electrically conductive layer structure may increase the stability.

In an embodiment, the first sub-portion may be configured as a laser stop layer to avoid the laser energy damaging the dielectric layer in the cavity bottom; the second sub-portion may be an extension portion of the first sub-portion. Therefore, the two portions remaining at the edge portion may also void the undercut between the sidewall and bottom wall, while etching, and then case/seal the void in the encapsulation as the undercut may be too small to be filled.

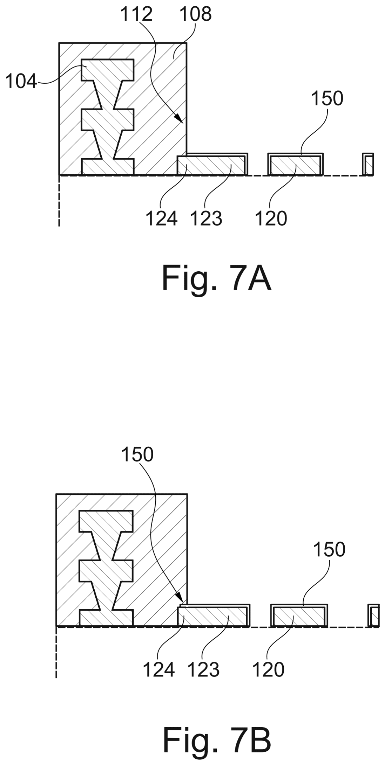

In an embodiment, the first sub-portion comprises the covering electrically conductive layer structure. In a further embodiment, the second sub-portion is free of the covering electrically conductive layer structure. In a further embodiment, the second sub-portion comprises a part of the covering electrically conductive layer structure. In an embodiment, the covering electrically conductive structure partially extends beyond the sidewall of the cavity. In an embodiment, the covering electrically conductive structure is partially embedded in and/or covered by at least one electrically insulating layer structure of the stack. Corresponding embodiments are shown for example in Figures 7A and 7B.

In an embodiment, the electrically insulating layer structure at the sidewall of the cavity may define a clear cut between first sub-portion and second sub-portion, wherein no covering electrically conductive layer structure is located in the sidewall. In another embodiment, a part of the covering electrically conductive layer structure extends into the sidewall, so that the first sub-portion partially extends into the sidewall and is covered. If the covering layers extend into the sidewall, the protection functionality may be increased.

In an embodiment, the covering electrically conductive layer structure and/or the first electrically insulating layer structure comprises a low phosphorus material/surface, for instance, ENIG with a low phosphorus in electroless nickel layer. The composition of low phosphorus may diffuse into the IMC layer with the reaction of the nickel and the tin. Thus, the low phosphorus may remain on the top surface of the covering electrically conductive layer and partially remain on the sidewall of the covering electrically conductive layer. Thereby, solderability may be increased, in particular due to at least one of better wetting, reduced oxidation, reduced brittleness. Moreover, the conductivity and the heat thermal fatigue resistance (component embedded in the cavity of the stack may result in a lot of heat which has no channel to dissipate) may be increased with the low phosphorus, thus the reliability/life time and function of the component carrier can be improved.

In an embodiment, the covering electrically conductive layer structure comprises ENIG or ENEPIG. These are examples of well established and reliable surface finished. In an embodiment, the covering electrically conductive layer structure is (essentially) free of palladium (e.g. in case of ENIG). Palladium (for example Pd/Au) may be costly and cumbersome to handle during manufacture (see above). Using an established surface finish process (such as ENIG) may save costs/efforts and increase the efficiency.

In an embodiment, the component carrier further comprises an additional material on an upper surface of the covering electrically conductive layer structure. Such an additional material may improve the electric connection between stack (electrically conductive layer structure with covering electrically conductive layer structure) and pads of the component. In an embodiment, the additional material is a solder material, in particular a solder bump. With the solder bump attaching on the covering electrically conductive layer, there may be soldering proceeded in the reflow. Then, the IMC layer may be formed with good bonding performance with the reaction between the nickel and tin of the solder bump due to the proper surface finishing process under the high temperature at the lower side of the solder bump. Therefore, a good basis for the component connection with the soldering structure may be provided.

In an embodiment, the additional material may comprise solder, e.g. solder bump/ball (e.g., made of tin or a tin-based alloy). The additional material may form a conductive bridge between two electric contacts, ensuring a reliable electrical connection. The additional material may provide a low-resistance path for current flow, crucial for electronic performance. The additional material may create a strong mechanical attachment between components (e.g., in FC BGA: flip chip ball grid arrays (BGAs). It may prevent movement and maintain contact even under stress or vibration. The additional material may further act as a buffer for thermal expansion, absorbing mechanical stress and preventing cracks in solder joints. The additional material may melt with high temperature and surface tension may pull the component into perfect alignment with the pads. In an embodiment, solder joints may transfer heat from components (e.g., chips, processors) to the PCB, aiding in thermal management. In a further embodiment, the additional material may provide a protective layer that prevents oxidation of underlying metals, ensuring long-term reliability. Due to the good IMC formation described previously at the bonding surface of bumps and the covering electrically conductive layer of the component carrier, the component carrier can bond with the component in a very good manner without peeling off or cracking.

In an embodiment, the additional material is arranged only on said upper surface. In an embodiment, the lateral surfaces of the at least one electrically conductive layer structure of the first portion and the respective covering electrically conductive layer structure are free of the additional material. In these embodiments, the additional material may be placed on the main/upper surface, while in particular the lateral surfaces remain free of the additional material. This may save material costs, since the additional material may not be necessary at the lateral surfaces (in particular already protected by the covering electrically conductive layer structure).

In an embodiment, the additional material bonding with covering electrically layer structure may comprise phosphorus. In an embodiment, the additional material comprises a non-constant thickness (e.g. a ball or bump shape. In an embodiment, phosphorus may improve the properties of the additional/solder material, e.g. reduce surface tension, reduce oxidation, enhance mechanical properties.

In an embodiment, the component carrier further comprises a third electrically insulating layer structure provided in the cavity on the at least one electrically conductive layer structure of the first portion and/or on the exposed part of the first main surface. This may provide the advantage that the delicate electric contacts may be well protected. The third electrically insulating layer structure may serve as an embedding/encapsulation material that embeds the electrically conductive layer structure (and the covering electrically conductive layer structure). The third electrically insulating layer structure may also cover the exposed first main surface. In an embodiment, the third electrically insulating layer structure may also encapsulate the additional material. In a further embodiment, the third electrically insulating layer structure may (at least partially) embed/encapsulate the (electrically connected) component. In an embodiment, the third electrically insulating layer structure may partially or fully fill the cavity.

In an embodiment, the third electrically insulating layer structure comprises a different composition and/or different structure than another one of the plurality of electrically insulating layer structures. For example, the third electrically insulating layer structure may be optimized for encapsulation, e.g. a resin without filler particles for better resin flow around the components to be embedded.

In an embodiment, the third electrically insulating layer structure is provided only between the structures of the first portion (i.e. the gaps). In an embodiment, the third electrically insulating layer structure is provided on the exposed portion of the first main surface. Thereby, the free spaces between structures/traces of the first portion (where the first main surface is exposed) can be filled first in an efficient and reliable manner. Thereby, stability and performance may be increased. Moreover, first filling of the gaps can insure the gaps filled completely without void before the component embedded in.

In a specific embodiment, the component may comprise material for forming the third electrically insulating layer structure, when placed in the cavity. The component may have a film attached on the side which may be connected with the electrically conductive layer structure in the cavity. When the component is placed in the cavity and is aligned with the electrically conductive layer structure, the thermal compression bonding will bond the component with the component carrier in the cavity and, at the same time, it may also melt the film attached on the component. Then, the liquid will flow to the gap and fills into the gap. After bonding, the gap will be also filled. This technology may provide the advantage that the gap filling and component embedding will be finished in a efficient and good quality manner.

In an embodiment, at least a part of the first portion (the structures of the first portion) defines electric contacts, in particular at least one of pads, terminals, traces, etc. The electric contacts of the first portion may hence be used to directly electrically connect a component in the cavity.

In an embodiment, the component carrier comprises a component connected to the at least one electrically conductive layer structure, in particular electrically connected to at least one electric contact of the first portion (covered by the covering electrically conductive layer structure). The component can directly bond with the electrically conductive layer structure with the covering electrically conductive layer structure. The direct connection between the component and the component carrier via the interconnection structure can provide a short electrical signal transmission path, so that the integrity of the signal may be improved and the loss of the signal may be reduced; meanwhile, the transmission speed between the component and the component carrier may be increased, which is advantageous for high performance computing, such as for the application of an AI server.

In an embodiment, the additional material is arranged between the electric contact of the component and the electric contact of the stack (it may be provided on the component carrier or it may be provided on the component or it may be provided on the both elements). Thereby, efficient and reliable electric connection in the cavity may be enabled as the additional material provides a good bonding interface for the component carrier and component.

In an embodiment, the component is configured as a bridge element. This may provide the advantage that surface-mounted components may be electrically connected via the bridge element. Accordingly, an important functionality may be efficiently embedded in the stack. Therefore, the signal transmission path or the communication path among the components in the package may be significantly reduced, and the integrity of the electricity may be improved in the whole package. Besides that, the bridge can have a high density and very fine line structuring, thereby reducing the density and the width/space of the component carrier, into which the bridge will be embedded. The bridge may be made of silicon or glass which has the advantage to realize the high density and fine line structuring with very good electrical performance compared the organic material which is used in the component carrier, so that it can improve the yield for the high density with fine line structuring package. Therefore, it may be very suitable for high performance computing.

In the context of the present document, the term "bridge element" may in particular refer to any element that may function as an electric interconnection between (active/passive) components, in particular electric/electronic components. In an example, the bridge element may require at least two (exposed) electrically conductive terminals to connect respectively to the components. In a more sophisticated example, the bridge element may comprise a plurality of terminals for (inter-) connecting two or more components. The electrically conductive terminals (preferably these terminals are exposed at the same main surface (top main surface) of the bridge element) may be interconnected by an electrical interconnection arranged in the bridge element.

A bridge element may particularly denote a component configured for providing electric interconnections. It may comprise a plurality of electrically conductive structure with high density configured for establishing an electrically conductive connection among the components which will be mounted on the component carrier and/or an upper side of the interposer. The bridge can be made of inorganic material such as silicon, ceramic, glass or other inorganic material or organic material. The bridge can have a high density and very fine line structuring, then it may reduce the density and the width/space of the component carrier, in which the bridge will be embedded. In an embodiment, the bridge is made of silicon or glass which has a big advantage to realize the high density and fine line structuring with very good electrical performance compared the organic material which is used in the component carrier. Electrically conductive terminals and electric interconnection may hence be arranged in a "U"-shape, when seen in a (specific) cross-section of the bridge element. In particular, the bridge element may comprise a plurality of "U"-shapes, whereby a larger "U" surrounds a smaller "U". The (organic or inorganic) bridge element may include further structures with functionalities beyond the interconnection between component, for example resistance measurements, ground, thermal dissipation, etc.

In an embodiment, the component carrier further comprises an encapsulation material encapsulating the component. In an embodiment, the encapsulating material is in contact with the third electrically insulating layer structure. In a further embodiment, the encapsulation material (at least partially) comprises the third electrically insulating layer structure. Encapsulation of electric contacts and/or components may increase stability and reliability of the stack functionality. The encapsulating material may directly encapsulate the cavity and gaps between the electrically conductive layer structure on the first surface in the cavity with the same material of the first and/or second electrically insulating layer structure. This may provide the advantage that the encapsulation can be done one time with the second electrically insulating layer structure formation in an efficient manner.

In an embodiment, forming the cavity comprises at least one of the following features: i) partially covering the at least one electrically conductive layer structure with a release layer, ii) providing at least the second electrically insulating layer structure on the release layer and/or on the first main surface of the first electrically insulating layer structure, iii) removing a part of at least the second electrically insulating layer structure on the release layer to thereby form the cavity. In an embodiment, the method further comprises removing the release layer (subsequently). This embodiment may enable an efficient and reliable technique to provide the cavity with the exposed electrically conductive layer structure (first portion). The release layer may define which portion of the electrically conductive layer structure will be the first portion and which portion of the electrically conductive layer structure will be the second portion. The second portion may be the portion, where no second electrically insulating layer structure is removed, while the first portion may be the portion, where the part of the second electrically insulating layer structure is removed. To separate said part to be removed, the second electrically insulating layer structure may be cut, e.g. by drilling, in particular laser drilling. The drilling location may further define where the first portion and the second portion will be situated. The drilling location may be defined by the lateral edges of the release layer (for example, the release ink).

In an embodiment, the method further comprises forming the covering electrically conductive layer structure on the exposed electrically conductive layer structure after the formation of the cavity. In another embodiment, the covering electrically conductive layer structure is formed before forming the cavity in the second electrically insulating layer structure. Depending on the desired application, one of these approaches may be preferable. The first case may yet need less process steps.

In an embodiment, the method, further comprises: providing a third electrically insulating layer structure and/or an encapsulation material in free spaces between structures/traces of the first portion of the at least one electrically conductive layer structure and/or on the exposed part of the first main surface. Performance and stability may be enhanced by such an embedding of electrically conductive structures.

In an exemplary embodiment, the embedded component has a resin film (kind of resin) attached on the surface of the component, and, when the component is bonded on the pads exposed in the cavity by thermal compressed bonding process, said resin will be melted. The (partially) melted resin then flows in the gaps, thereby filling and encapsulating the electrically conductive layer structures and the first main surface. This process may enable an especially efficient distribution of encapsulation material.

In an exemplary embodiment, the component is firstly arranged in the cavity, and then, lamination with dielectric material is used to encapsulate the whole free space, including the gaps between pads. Thus, the third electrically insulating layer structure as encapsulation material can be formed at the same time as the lamination on the surface of the side wall of the cavity.

In an embodiment, the method further comprises: placing a component into the cavity and onto the covering electrically conductive layer structure, in particular with an additional material in between. Thereby, an efficient embedding and electric connection may be enabled. In an embodiment, the method further comprises: filling the cavity with an encapsulation material, in particular thereby encapsulating the component in the cavity. The component (and the electric connections) may be well protected by such encapsulation.

In an embodiment, the method comprises covering the electrically conductive layer structure by a covering layer structure. In an example, the covering layer structure is the covering electrically conductive layer structure. In another example, the covering layer structure comprises an organic material, e.g. organic solder protection (OSP), or ENIG or ENIPIG or ENEPIG. Said material may only be present during the manufacture method and not in the final component carrier product.

In an embodiment, the electrically insulating layer structure covering the second portion is different from the plurality of electrically insulating layer structure. For example, the electrically insulating layer structure covering the second portion comprises a different material and/or a different thickness compared to one or more other electrically insulating layer structures of the stack. If the electrically insulating layer structure covering the second portion is thicker and/or more robust (e.g. configured as a reinforced layer structure and/or a core layer), the cavity for the component may be formed more efficiently and reliably.

In an embodiment, the electrically conductive layer structure defines the sidewall at the edge area between the sidewall and bottom wall (of the cavity). Such kind of design may act as a laser stop layer during cavity formation, thus it may avoid the damage of the main surface of the first electrically insulating layer structure by the laser energy. Meanwhile, such kind of design may also void the undercut between the sidewall and bottom wall while etching and, then case (seal, encapsulate) the void in the encapsulation as the undercut may be too small to fill.

In an embodiment, the sidewall of the cavity is laterally delimited by the second electrically insulating layer structure and the second portion of the electrically conductive layer structure. The second portion of the electrically conductive layer structure is embedded in (covered by) electrically insulating material of the second electrically insulating layer structure and thereby also defines a part of the cavity sidewall.

In an embodiment, the sidewall of the cavity is further laterally delimited (besides the second electrically insulating layer structure and/or the second portion of the electrically conductive layer structure) by the covering electrically conductive layer structure (on top of the second portion of the electrically conductive layer structure). In this embodiment, the covering electrically conductive layer structure extends vertically along a part of the sidewall (compare Figure 7B), thereby defining a part of the sidewall of the cavity.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of an component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Eletroless Palladium Immersion Gold (ENEPIG) gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1 illustrates a cross-section of a component carrier cavity, according to an exemplary embodiment of the invention.
Figure 2 illustrates a component carrier with a component embedded in a cavity, according to an exemplary embodiment of the invention.
Figure 3 illustrates the component carrier of Figure 1 as part of a multilayer stack, according to an exemplary embodiment of the invention.
Figure 4A, Figure 4B, and Figure 4C illustrate microscopic images of the covering electrically conductive layer structure, according to exemplary embodiments of the invention.
Figure 5 shows a conventional circuit board with embedded components.
Figure 6A, Figure 6B, Figure 6C, and Figure 6D show a process of manufacturing a component carrier, according to an exemplary embodiment of the invention.
Figure 7A and Figure 7B respectively illustrate a cavity edge portion, according to exemplary embodiments of the invention.

### Detailed Description of the Drawings

**Figure 1** illustrates a cross-section of a component carrier cavity 110 in a component carrier stack 101, according to an exemplary embodiment of the invention. The stack 101 comprises electrically conductive layer structures 104, 120 and electrically insulating layer structures 102, 108 (compare also Figure 3). The cavity 110 is formed in the stack 101 and is delimited by a bottom wall 111 and sidewalls 112. The bottom wall 111 is partially delimited/defined by a first main surface 106 of a first electrically insulating layer structure 102 (in the Figures illustrated schematically) of the plurality of electrically insulating layer structures 102, 108. On said first main surface 106, there is provided the at least one electrically conductive layer structure 120, comprising a horizontal/planar layer of isolated islands (configured as traces and/or pads).

The electrically conductive layer structure 120 comprises a first portion 121 that is exposed in the cavity 110. The first portion 121 comprises a first plurality of structures (traces) that are all exposed at the bottom of the cavity 110, i.e. not covered by an electrically insulating layer structure 102. The electrically conductive layer structure 120 further comprises a second portion 122 covered by a second electrically insulating layer structure 108 of the plurality of electrically insulating layer structures 102, 108. The second electrically insulating layer structure 108 defines at least partially the lateral/side wall 112 of the cavity 110. The second portion 122 comprises a second plurality of structures (traces) at are not exposed at the bottom of the cavity 110, i.e. covered by the second electrically insulating layer structure 108.

The first portion 121 of the electrically conductive layer structure 120 comprises (each of the structures/traces of the first portion 121 comprises) a covering electrically conductive layer structure 150. In this example, the second portion 122 does not comprise (is free of) the covering electrically conductive layer structure 150. Thus, the covering electrically conductive layer structure 150 covers the main surface and the lateral surfaces of the electrically conductive layer structure 120 of the first portion 121, and the covering electrically conductive layer structure 150 covers the structures of the first portion 121 that are not covered by the first main surface 106 (in other words, everything but the bottom surface of the first portion 121).

The bottom wall 111 of the cavity 110 is delimited by the first portion 121 of the electrically conductive layer structure 120 and the exposed part of the first main surface 106. In this example, there are no other structures that define the bottom wall 111 of the cavity 110. The sidewall 112 of the cavity 110 is laterally delimited by the second electrically insulating layer structure 108 (can also be one or a plurality of layer structures) of the stack 101 or by the second electrically insulating layer structure 108 and the second portion of the electrically conductive layer structure 122. The second electrically insulating layer structure 108 is in direct contact with the first main surface 106, and the sidewall 112 is defined by the second electrically insulating layer structure 108.

**Figure 2** illustrates a component carrier 100 with a component 130 embedded in a cavity 110, according to an exemplary embodiment of the invention. The cavity 110 can be configured in a comparable manner to the embodiment of Figure 1. Additionally, the first electrically insulating layer structure 102 below the cavity bottom wall 111 (defining the first main surface 106) is schematically shown. On top of the covering electrically conductive layer structure 150 of the first portion 121, an additional material (e.g. solder material, in particular comprising tin) 170 has been provided. The first portion 121 defines electric contacts (pads) that can be electrically contacted via the covering electrically conductive layer structure 150 and the additional material 170.

The component 130 is placed into the cavity 110 and is electrically connected via electric pads 131 of the component 130 to the electrically conductive layer structure 120 (electrically connected to at least one electric contact of the first portion 121) through the additional material 170 and the covering electrically conductive layer structure 150.

**Figure 3** illustrates the component carrier 100 of Figure 1 as part of a multilayer stack 101, according to an exemplary embodiment of the invention. The component carrier 100 comprises a core layer structure 109 (e.g. cured reinforced resin such as FR4). On top of the core layer structure 109, there is arranged an upper build-up structure with a plurality of electrically insulating layer structures 102 and electrically conductive layer structures 104 (shown schematically).

In another embodiment, the cavity 110 can also extend from the surface of the core layer structure 109 (into the core layer structure) or the cavity 110 can extend through the core layer structure 109. In a further embodiment, the second electrically insulating layer structure 108 is configured as a core layer, for example by using a fully cured (reinforced) resin material, such as FR4).

Below the core layer structure 109, there is arranged a lower build-up structure with another plurality of electrically insulating layer structures 102 and electrically conductive layer structures 104 (shown schematically). On top of the upper build-up structure, there is arranged the stack configuration described for Figure 1. Below the lower build-up structure, there is arranged a layer 103 with via through-connections.

**Figure 4A, Figure 4B, and Figure 4C** illustrate microscopic images of the covering electrically conductive layer structure 150, according to exemplary embodiments of the invention.

Figure 4A: on top of the stack 101, in the cavity 110, the electrically conductive layer structure 120 (first portion 121) can be seen. On top, there can be seen the additional material 170 in form of a solder (tin-comprising) bump, thereby, the additional material 170 comprises a non-constant thickness.

Figure 4B: the detailed view of the interface between the electrically conductive layer structure 120 and the additional material 170 shows the covering electrically conductive layer structure 150, in this example comprising two layers, an intermediate layer 151, comprising nickel, and a protective layer 152 (too thin to be seen in this magnification, around 100 nm), comprising gold (e.g. ENIG). The protective layer 152 is exposed to the internal space of the cavity 110 and the intermediate layer 151 below is thicker than the protective layer 152. No further layer is arranged between the intermediate layer 151 and the protective layer 152, and no further layer is arranged between the electrically conductive layer structure 120 of the first portion 121 and the intermediate layer 151. In this example, the intermediate layer 151 also covers the sidewall of the electrically conductive layer structure 120.

Figure 4C: the intermediate layer 151 of the covering electrically conductive layer structure 150 defines a foot-structure 160 less than 2 µm, here a nickel-foot, at the bottom wall 111 of the cavity 110 at an interface of the first main surface 106 and the covering electrically conductive layer structure 150. This structure is a relic from the manufacture process and may enhance adhesion between covering electrically conductive layer structure 150 and first main surface 106.

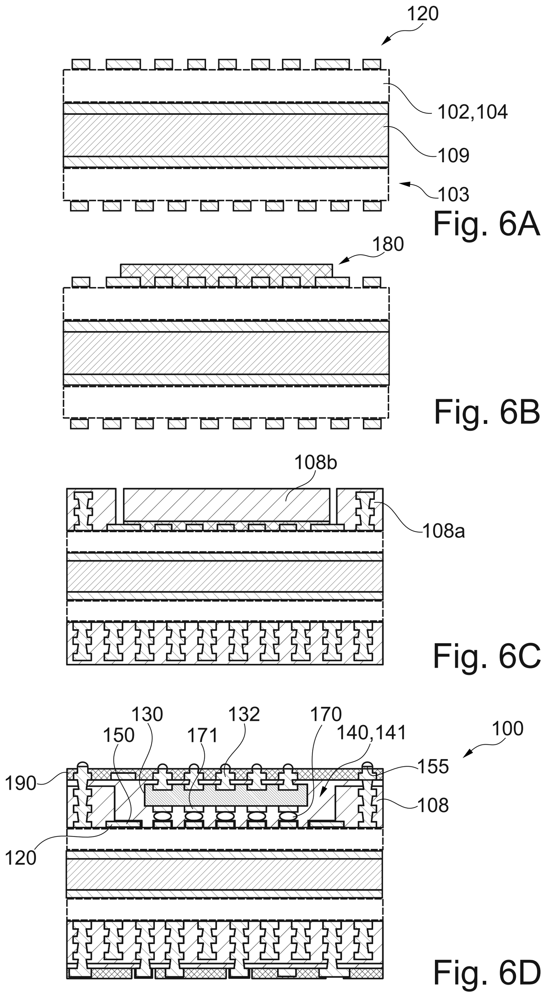

**Figure 6A, Figure 6B, Figure 6C, and Figure 6D** show a process of manufacturing a component carrier 100, according to an exemplary embodiment of the invention.

Figure 6A: there is provided a preform of the stack 101 with a core layer structure 109 sandwiched between electrically conductive layers (e.g. copper). On top and at the bottom, there are arranged further layer build-ups, i.e. an upper layer build-up with electrically insulating layer structures 102 and electrically conductive layer structures 104 and a lower layer build-up with further electrically insulating layer structurer 102 and further electrically conductive layer structures 104. The upper main surface of the outermost layer of the stack 101 (here the first electrically insulating layer structure 102) defines the first main surface 106. On said first main surface 106, there is provided (e.g. by plating) the electrically conductive layer structure 120.

Figure 6B: a release layer 180 is provided to cover a portion of the electrically conductive layer structure 120. Said portion is the future first portion 121, while the future second portion 122 is not covered by the release layer 180.

Figure 6C: a second electrically insulating layer structure 108 is provided (e.g. by lamination) on the first main surface 106. Thereby, also the release layer 180 is covered by the second electrically insulating layer structure 108. Then, via connections are formed in the second electrically insulating layer structure 108. A part 108b of the second electrically insulating layer structure 108 is separated (e.g. by laser cutting to second electrically insulating layer structure 108 perpendicular to the lateral edge of release layer along vertical direction) from the rest 108a of the second electrically insulating layer structure 108. Said part 108b is situated on the release layer 180, so that said part 108b can be easily removed (e.g. by applying ultrasonic wave or laser trimming) after separation. By removing said part 108b of the second electrically insulating layer structure 108, the cavity 110 is formed. Subsequently, the release layer 180 is removed (stripped).

Afterwards, the covering electrically conductive layer structure 150 is provided on the exposed electrically conductive layer structure 120 (i.e. the first portion 121), i.e. after the formation of the cavity 110, The second portion 122 is covered by the second electrically insulating layer structure 108, so that the covering electrically conductive layer structure 150 cannot cover the second portion 122. A design comparable to Figure 1 or Figure 3 is obtained.

Figure 6D: an additional material 170 is provided on the covering electrically conductive layer structure 150 and then, a component 130 is placed in the cavity 110 on said additional material 170 for electric connection. A third electrically insulating layer structure 140 is provided in the free spaces (gaps) between structures of the first portion 121 of the electrically conductive layer structure 120 and on the exposed part of the first main surface 106. The third electrically insulating layer structure 140 functions as an encapsulation material 141 and fills the whole cavity 110, thereby encapsulating the component 130 and the electric connections.

A further layer structure 190 is provided on the main surface of the stack 101. The further layer structure 190 is the outermost (electrically conductive layer structure 104) layer of the stack 101, and configured as at least one of solder resist, surface finish, organic solder protection. The further layer structure 190 can be (at least partially) covered by a further covering (electrically conductive) layer structure 155. Even though the covering electrically conductive layer structure 150 can also be a surface finish, the material of the further covering layer structure 155 and the covering electrically conductive layer structure 150 can be different or same. In this way, a highly reliable and high mechanical robust double connection of an embedded component is achieved.

**Figure 7A and Figure 7B** respectively illustrate a cavity 110 edge portion, according to exemplary embodiments of the invention. The electrically conductive layer structure 120 on said first main surface 106 comprises an edge portion, positioned across the sidewall 111 of the cavity 110, so that a first sub-portion 123 of the edge portion is exposed in the cavity 110 and a second sub-portion 124 of the edge portion is not exposed in the cavity 110 and is embedded in the stack 101 (in the second electrically insulating layer structure 108). The edge portion is a region of a structure/trace of the electrically conductive layer structure 120 that comprises an interface of a first portion 121 and a second portion 122. While the first portion 121 of said structure is exposed (first sub-portion 123), the second portion 122 of said structure is not exposed (second sub-portion 124). Thus, the first sub-portion 123 comprises the covering electrically conductive layer structure 150.

Figure 7A: the covering electrically conductive layer structure 150 does not extend beyond the sidewall 112 (in the horizontal direction) of the cavity 110. Instead, the second electrically insulating layer structures 108 (sidewall 112) defines a clear cut between the first sub-portion 123 and the second sub-portion 124. In an embodiment, the first sub-portion 123 may be configured as a laser stop layer to avoid the laser energy damaging the dielectric layer in the cavity bottom, and the second sub-portion 124 may be an extension portion of the first sub-portion 123. Therefore, the two portions remaining at the edge portion may also void the undercut between the sidewall and bottom wall while etching and then case/seal the void in the encapsulation as the undercut may be too small to fill.

Figure 7B: the covering electrically conductive layer structure 150 partially extends (in the horizontal direction) beyond the sidewall 112 of the cavity 110. The covering electrically conductive layer structure 150 is thus partially embedded in and covered by the second electrically insulating layer structure 108 of the stack 101. Thereby, the interface between the covered portion 123 and the not-covered portion 124 is smooth and well protected by the electrically insulating material. In this embodiment, the sidewall of the cavity 112 of the cavity 110 is defined by the second electrically insulating layer structure 108, the second portion of the electrically conductive layer structure 122 (in particular the second sub-portion 124 of the edge portion), and the covering electrically conductive layer structure 150 on top of said second sub-portion 124. In this embodiment, the covering electrically conductive layer structure 150 extends vertically along a part of the sidewall 112. Such a design may at least partially avoid the damage of laser energy to the sidewall and/or the over-etching of the sidewall, which may result in the delamination at the edge of sidewall and bottom wall.

### Reference signs

- 100: Component carrier
- 101: Stack
- 102: First electrically insulating layer structure
- 103: Through-connection layer
- 104: Further electrically conductive layer structure(s)
- 106: First main surface
- 108: Second electrically insulating layer structure
- 109: Core layer structure
- 110: Cavity
- 111: Bottom (wall) of cavity
- 112: Sidewall of cavity
- 120: Electrically conductive layer structure
- 121: First portion
- 122: Second portion
- 123: First sub-portion
- 124: Second sub-portion
- 130: Component
- 131: Component electric connections
- 140: Third electrically insulating layer structure
- 141: Encapsulation material
- 150: Covering electrically conductive layer structure
- 151: Intermediate layer, nickel layer
- 152: Protection layer, gold layer
- 155: Further covering layer structure
- 160: Foot structure, nickel foot
- 170: Additional material, solder bump
- 180: Release layer
- 190: Further layer structure

## Claims

1. A component carrier (100) comprising:
a stack (101) comprising at least one electrically conductive layer structure (120) and a plurality of electrically insulating layer structures;
a cavity (110) formed in the stack (101) and being delimited by a bottom wall (111) and a sidewall (112);
wherein the bottom wall (111) is partially delimited by a first main surface (106) of a first electrically insulating layer structure (102) of the plurality of electrically insulating layer structures;
wherein the at least one electrically conductive layer structure (120) is provided in/on the first main surface (106);
wherein the at least one electrically conductive layer structure (120) comprises:
a first portion (121) exposed in the cavity (110), and
a second portion (122) covered by a second electrically insulating layer structure (108) of the plurality of electrically insulating layer structures; and
wherein the first portion (121) of the at least one electrically conductive layer structure (120) comprises a covering electrically conductive layer structure (150) in addition to the structure of the second portion (122).

2. The component carrier (100) according to claim 1,
wherein the covering electrically conductive layer structure (150) covers the main surface and the lateral surfaces of the at least one electrically conductive layer structure (120) of the first portion (121); and/or
wherein the covering electrically conductive layer structure (150) covers the structure of the first portion (121) that is not covered by the first main surface (106).

3. The component carrier (100) according to claim 1 or 2,
wherein the covering electrically conductive layer structure (150) comprises at least two layers (151, 152), in particular exactly two layers.

4. The component carrier (100) according to one of the preceding claims,
wherein the covering electrically conductive layer structure (150) comprises an intermediate layer (151), in particular comprising nickel, and a protective layer (152), in particular comprising gold.

5. The component carrier (100) according to claim 4,
wherein the protective layer (152) faces, in particular is exposed to, the internal space of the cavity (110); and/or
wherein the intermediate layer (151) is thicker than the protective layer (152); and/or
wherein no further layer is arranged between the intermediate layer (151) and the protective layer (152); and/or
wherein no further layer is arranged between the electrically conductive layer structure (120) of the first portion (121) of the at least one electrically conductive layer structure (120) and the intermediate layer (151).

6. The component carrier (100) according to one of the preceding claims,
wherein the covering electrically conductive layer structure (150), in particular the intermediate layer (151), defines a foot-structure (160), in particular a nickel-foot, at the bottom wall (111) of the cavity (110),
in particular at an interface of the first main surface (106) and the covering electrically conductive layer structure (150).

7. The component carrier (100) according to one of the preceding claims,
wherein a further electrically conductive layer structure (190) of the plurality of electrically conductive layer structures (104) is provided on a surface, in particular main surface, of one of the plurality of electrically insulating layer structures (108), that defines at least partially the sidewall (112) or is arranged below the cavity (110), and
wherein the further electrically conductive layer structure (190) comprises a further covering electrically conductive layer structure (155) that is different from the covering electrically conductive layer structure (150) on the first portion (121) of the at least one electrically conductive layer structure (120),
in particular wherein the further electrically conductive layer structure (190) is the outermost electrically conductive layer structure (104) of the stack (101),
in particular the outermost electrically conductive layer structure at the side of the cavity (110) opening.

8. The component carrier (100) according to one of the preceding claims,
wherein the at least one electrically conductive layer structure (120) in/on said first main surface (106) comprises an edge portion, positioned across the sidewall (111) of the cavity (110),
so that a first sub-portion (123) of the edge portion is exposed in the cavity (110) and a second sub-portion (124) of the edge portion is not exposed in the cavity (110) and is embedded in the stack (101),
in particular in the second electrically insulating layer structure (108).

9. The component carrier (100) according to claim 8,
wherein the first sub-portion (123) comprises the covering electrically conductive layer structure (150).

10. The component carrier (100) according to claim 8 or 9,
wherein the covering electrically conductive structure (150) partially extends beyond the sidewall (112) of the cavity (110); and/or
wherein the covering electrically conductive structure (150) is partially embedded in and/or covered by at least one second electrically insulating layer structure (108) of the stack (101).

11. The component carrier (100) according to one of the preceding claims, further comprising:
an additional material (170) on an upper surface of the covering electrically conductive layer structure (150),
in particular
wherein the additional material (170) is arranged only on said upper surface; and/or
wherein the lateral surfaces of the at least one electrically conductive layer structure (120) of the first portion (121) and the respective covering electrically conductive layer structure (150) are free of the additional material (170); and/or
wherein the additional material (170) is a solder material, in particular a solder bump; and/or
wherein the additional material (170) comprises phosphorus; and/or
wherein the additional material (170) comprises a non-constant thickness.

12. The component carrier (100) according to one of the preceding claims, further comprising:
a third electrically insulating layer structure (140) provided in the cavity (110) on the at least one electrically conductive layer structure (120) of the first portion (121) and on the exposed part of the first main surface (106),
in particular
wherein the third electrically insulating layer structure (140) comprises a different composition and/or different structure than another one of the plurality of electrically insulating layer structures; and/or
wherein the third electrically insulating layer structure (140) is provided only between the structures of the first portion (121),
in particular on the exposed portion of the first main surface (106).

13. The component carrier (100) according to one of the preceding claims, further comprising:
a component (130) connected to the at least one electrically conductive layer structure (120), in particular electrically connected to at least one electric contact of the first portion (121),
in particular wherein the component (130) is configured as a bridge element.

14. The component carrier (100) according to one of the preceding claims, further comprising:
an encapsulation material (141) encapsulating the component (130),
in particular wherein the encapsulating material (141) is in contact with the third electrically insulating layer structure (140).

15. A method for manufacturing a component carrier (100), comprising:
providing a stack (101) comprising at least one electrically conductive layer structure (120) and a plurality of electrically insulating layer structures;
forming a cavity (110) in the stack (101), being delimited by a bottom wall (111) and a sidewall (112),
wherein the bottom wall (111) is partially delimited by a first main surface (106) of a first electrically insulating layer structure (102) of the plurality of electrically insulating layer structures, and
wherein the at least one electrically conductive layer structure (120) is provided in/on the first main surface (106);
providing a covering electrically conductive layer structure (150) on the at least one electrically conductive layer structure (120),
so that the at least one electrically conductive layer structure (120) comprises:
a first portion (121) exposed in the cavity (110), wherein the first portion (121) comprises the covering electrically conductive layer structure (150) in addition to the structure of a second portion (122), and
the second portion (122) covered by a second electrically insulating layer structure (108) of the plurality of electrically insulating layer structures.
